# EUROPÄISCHE PATENTSCHRIFT

(11) **EP 3 663 592 B1**
(45) Veröffentlichungstag und Bekanntmachung des Hinweises auf die Patenterteilung: **25.01.2023**
(21) Anmeldenummer: 18210173.3
(22) Anmeldetag: 04.12.2018
(51) Int. Cl.: F16B 5/06, H05K 5/00, F16B 21/02

(54) **VERBINDERSYSTEM**
CONNECTOR SYSTEM
SYSTÈME DE RACCORDEMENT

(43) Veröffentlichungstag der Anmeldung: 10.06.2020
(60) Teilanmeldung: 22206110.3
(73) Patentinhaber: Gustav Hensel GmbH & Co. KG, 57368 Lennestadt (DE)
(72) Erfinder: BAETZ, Marcus, 57399 Kirchhundem (DE)
(74) Vertreter: Brinkmann & Partner

(56) Entgegenhaltungen:
- EP-A1- 0 046 223
- DE-A1-102012 018 694
- FR-A3- 2 540 946

## Beschreibung

Die vorliegende Erfindung betrifft ein Verbindersystem.

Bei einer Vielzahl von Montageaufgaben, insbesondere wenn es darum geht ebene Flächenbereiche miteinander zu verbinden, muss in der Regel auf kraftschlüssige Verbindungsmittel zurückgegriffen werden. Beispielsweise bei der Verbindung von Gehäusen, Brettern, Flächenelementen allgemeiner Art werden diese in aller Regel verschraubt, mit Bolzen durchsetzt oder endgültig verklebt und dergleichen.

Aus der EP 0 046 223 A1 ist eine Spannverbindung für Rohre bekannt, wobei an der Außenseite von Rohrstücken an deren Endbereich ein Flansch mit einer Durchgangsbohrung angeordnet ist. 2 entsprechend zusammengefügte Rohre können so verdreht werden, dass die Durchgangsbohrungen sich gegenüberliegender Flansche zueinander fluchten. Somit kann ein Bolzen eingesetzt werden. Dieser kann ein Schraubbolzen oder ein Bolzen mit einer nockenartigen exzentrischen Erweiterung sein. Der exzentrische Bereich gelangt während einem Verdrehen des Bolzens um seine Längsachse an einem Bohrungsrand zur Anlage.

Verbindungssysteme für andere Bauelemente sind aus der DE 10 2012 018 694 A1 und der FR 2 540 946 A3 bekannt, bei welchen ein stabförmiges Verbindungselement in zueinander fluchtende Schlitze eingesetzt werden. Möglichkeiten zur sicheren Verspannung der Bauelemente sind nicht vorgeschlagen. Die Wirksamkeit der Verbindung ist für viele Anwendungsbereiche nicht ausreichend.

Der Erfindung liegt die **Aufgabe** zugrunde, ein Verbindersystem anzugeben, welches einfach herstellbar, einfach betätigbar und wirksam zur Verbindung insbesondere von Gehäusen und sonstigen flächigen Elementen verwendet werden kann.

Zur technischen **Lösung** dieser Aufgabe wird ein Verbindersystem mit den Merkmalen des Anspruchs 1 vorgeschlagen. Weitere Vorteile und Merkmale ergeben sich aus den Unteransprüchen.

Gemäß der Erfindung umfasst das Verbindersystem zwei Lagerböcke, die jeweils eine Öffnung aufweisen, die relativ zu einer Oberfläche befestigbar und derart positionierbar sind, dass die Öffnungen zueinander fluchten. Solche Lagerböcke können einzeln ausgefertigt und beispielsweise Befestigungselemente wie Schraublöcher, Federstifte, Nutfedersysteme und dergleichen umfassen. Weiterhin umfasst das Verbindersystem einen Verbindungsbolzen, der die Lagerböcke verbindend in die zueinander fluchtenden Öffnungen einsetzbar ist. Dieser Verbindungsbolzen kann, nachdem die Lagerböcke entsprechend positioniert werden, in die Öffnungen eingeschoben und dort verrastet werden. Dabei ist beim erfindungsgemäßen Verbindungssystem am Verbindungsbolzen einerseits und wenigstens einer Öffnung andererseits ein zueinander passendes Paar auf einem Vorsprung und einer Ausnehmung ausgebildet. So kann beispielsweise am Verbindungsbolzen ein Nocken oder ein Federsteg ausgebildet sein und in der Öffnung eine Nut. Es kann aber auch umgekehrt sein, dass eine Langnut im Verbindungsbolzen einen in die Öffnung ragenden Nocken aufnimmt. Der Verbindungsbolzen ist nur in einer Verdrehposition einschiebbar, da ansonsten der Vorsprung stört.

Der Verbindungsbolzen weist ein exzentrisch ausgeführtes Kopfstück auf, welches durch eine Erweiterung in einem Kreissegment gebildet ist. Im Lagerbock kann eine entsprechende Öffnung ebenfalls durch eine exzentrische Erweiterung in einem Kreissegment ausgebildet sein, sodass beide Erweiterungen miteinander zusammenwirken

Gemäß einem Vorschlag der Erfindung sind die Lagerböcke von vorneherein miteinander verbunden. So können sie beispielsweise auf einer Basisplatte angeordnet sein oder durch sonstige Verbindungsmittel wie beispielsweise auch Gewindestangen und dergleichen miteinander verbunden sein. Die auf diese Weise vorbereitend verbundenen Lagerböcke können nun direkt mit den Verbindungsbolzen bestückt werden. Werden die Lagerböcke beispielsweise durch Öffnungen von zu verbindenden Elementen gesteckt, so kann die Verbindung durch das Einschieben und Verdrehen des Verbindungsbolzens gesichert werden. Der Verbindungsbolzen kann verdreht werden, bis er gegen ein Anschlagelement stößt, welches gemäß einem Vorschlag der Erfindung vorgesehen ist. Weiterhin kann er in einer Position in einem Rastelement verrastet werden. Gemäß einem vorteilhaften Vorschlag der Erfindung sind Anschlagelement und Rastelement einstückig ausgebildet, indem beispielsweise an einem der Lagerböcke im Bereich der Öffnung ein Vorsprung ausgebildet ist, der mit einem Vorsprung am Verbindungsbolzen zusammenwirkt. Auch hier ist eine Umkehrung denkbar, dass ein Vorsprung im Bereich des Lagerbocks beispielsweise in eine Rastnut am Verbindungsbolzen einrastet und dergleichen.

Der Verbindungsbolzen weist gemäß einem konkretisierenden Vorschlag der Erfindung einen stegartigen Vorsprung auf. Der parallel zu einer Längsmittelachse des Verbindungsbolzens verläuft. Der Vorsprung ist nicht über die volle Länge ausgeführt, sondern so, dass die Endbereiche des Verbindungsbolzen frei bleiben. Auf diese Weise können sie in den Öffnungen geführt werden, ohne dass der Vorsprung stört.

Dieser Vorsprung am Verbindungsbolzen kann mit dem Vorsprung am Lagerbock zum Zwecke des Anschlags und der Verrastung zusammenwirken. Weiterhin kann der Vorsprung am Verbindungsbolzen als Anschlagelement beim Einschieben in die Öffnungen verwendet werden, um so die Einschubtiefe zu begrenzen.

Der Vorsprung wirkt mit einer Nut in der Öffnung des Lagerbocks zusammen, in welchem der Verbindungsbolzen eingeschoben wird.

Werden die Lagerböcke durch Öffnungen in zu verbindenden Teilen hindurchgeführt, ragen die Öffnungen auf einer Seite zueinander fluchtend heraus. In diese Öffnungen lässt sich der Verbindungsbolzen einstecken und verrasten, sodass die Verbindung hergestellt ist. Gemäß einem vorteilhaften Vorschlag der Erfindung sind die Lagerböcke derart ausgeführt, dass der Verbindungsbolzen beim Verdrehen in einem bestimmungsgemäß in die Öffnungen der Lagerböcke eingesetzten Zustand gegen eine von wenigstens einem der Lagerböcke durchragte Oberfläche verspannt wird. Das heißt, die Oberfläche ragt in den Bereich der lichten Öffnung des Lagerbocks, sodass beim Verdrehen des Verbindungsbolzens, der abgeflacht ausgeführt sein kann, eine Verspannung erfolgt.

Mit der Erfindung wird ein einfach ausführbares Verbindersystem bereitgestellt, mit welchem erweiterte Möglichkeiten über Bindung von Gehäusen, flächigen Elementen und dergleichen durchgeführt werden können.

Weitere Vorteile und Merkmale der Erfindung ergeben sich aus der folgenden Beschreibung anhand der Figuren. Dabei zeigen:
- Fig. 1: eine perspektivische Darstellung eines Ausführungsbeispiels für ein erfindungsgemäßes Verbindersystem;
- Fig. 2: eine Darstellung gemäß Fig. 1 in einer anderen Verbindungsposition;
- Fig. 3: eine Darstellung gemäß Fig. 2 aus einer anderen Perspektive;
- Fig. 4: eine Darstellung des Verbinders gemäß Fig. 1 in einer Anwendungsposition;
- Fig. 5: eine vergrößerte Detaildraufsicht auf den Verbinder gemäß Fig. 4 und
- Fig. 6: eine Darstellung gemäß Fig. 4 in einer Verbindungsposition.

In den Figuren sind gleiche Elemente mit gleichen Bezugszeichen versehen.

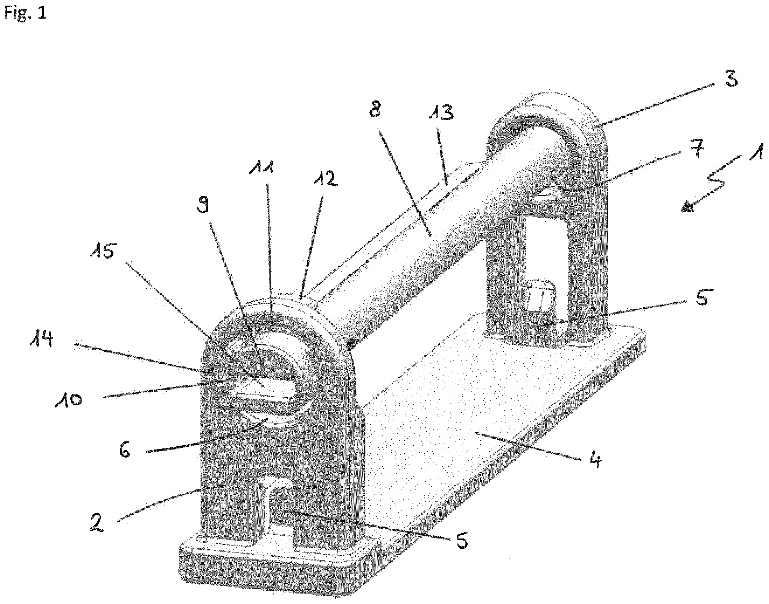

Die Figuren 1 bis 3 zeigen ein Ausführungsbeispiel für ein Verbindungssystem gemäß der Erfindung.

Das Verbindungssystem 1 umfasst einen Lagerbock 2 und einen Lagerbock 3. Im gezeigten Ausführungsbeispiel sind die Lagerböcke 2 und 3 auf einer Basisplatte 4 angeordnet. Die Basisplatte 4 weist im gezeigten Ausführungsbeispiel Befestigungselemente 5 in Form von Federhaken auf.

Der Lagerbock 2 hat die Öffnung 6, der Lagerbock 3 die Öffnung 7. Wie die Figuren zeigen, ist die Öffnung 7 im Wesentlichen kreisrund. Gleiches gilt auch für die Öffnung 6, die jedoch im Bereich 11 eine exzentrische Erweiterung im Frontbereich aufweist.

Weiterhin umfasst das Verbindungssystem einen Verbindungsbolzen 8, der im Bereich seiner Stirnfront 9 eine Erweiterung des Bolzens 10 aufweist, woraus sich eine Exzentrik ergibt. Die Erweiterung des Bolzens 10 läuft in der Erweiterung der Öffnung 11. Die Erweiterung der Öffnung ist nicht durchgehend im gezeigten Ausführungsbeispiel, sondern nur auf der Oberfläche ausgeführt.

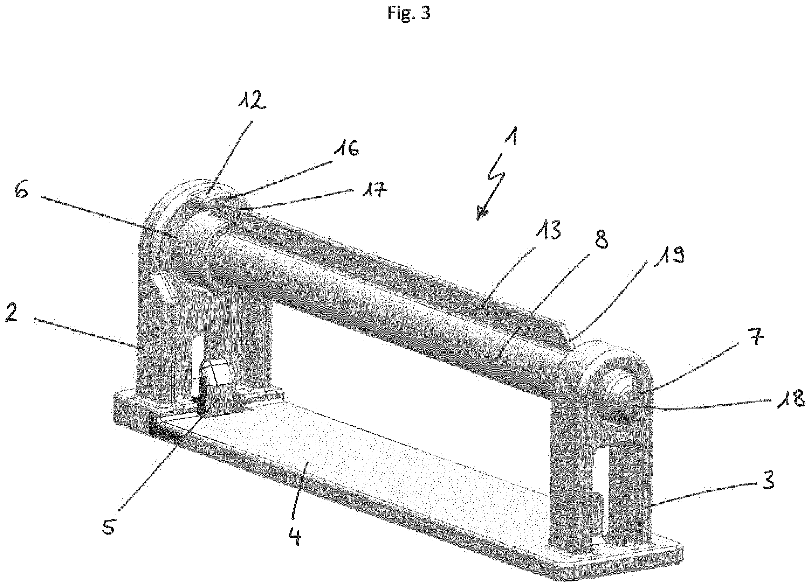

Wie insbesondere Figur 3 zeigt, ist ein Anschlag-/Rastnocken 12 auf der Rückseite des Lagerbocks 2 angeordnet. Auf diesem läuft der Federsteg 13 des Verbindungsbolzens 8 auf, in den er die Auflauframpe 16 entlangläuft, bis er in der Rastnut 17 einrastet.

Die Figuren zeigen, dass der Bolzenquerschnitt 18 abgeflacht ausgeführt ist. Der Federsteg 13 ist so lang ausgeführt, dass er eine hintere Anschlagkante 19 bildet, mit welcher der Bolzen gegen den Lagerbock 3 aufläuft.

Im gezeigten Ausführungsbeispiel ist die Basisplatte 4 so ausgeführt, dass die Höhen der Lagerböcke an eine vorgesehene Einbauposition angepasst sind. Die Öffnungen 6 und 7 fluchten und bieten somit eine Einführung für den Verbindungsbolzen 8.

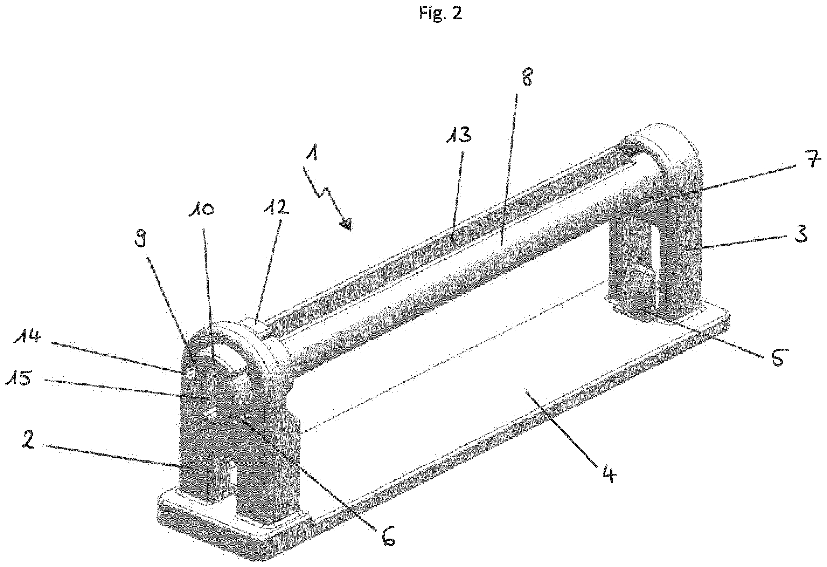

Es zeigt sich, dass der Verbindungsbolzen 8 nur in der in Figur 1 gezeigten Position überhaupt in den Lagerbock 2 einführbar und bis zum Lagerbock 3 durchführbar ist, da der Federsteg 18 in der Nut 14 des Lagerbocks 2 läuft. Erst in der in Figur 1 gezeigten Einsteckposition lässt sich der Verbindungsbolzen 8 verdrehen. Zu diesem Zweck kann in den Betätigungsschlitz 15 ein entsprechendes Werkzeug, beispielsweise ein Schraubenzieher eingesteckt werden. Bei der Verdrehung wird zum Einen die im Bereich des Lagerbocks 2 liegende Stirnkante des Federstegs 13 über die Auflauframpe 16 in die Rastnut 17 des Anschlag- und Rastnocken 12 auflaufen, zum Anderen die exzentrische Erweiterung 10 im Stirnflächenbereich des Verbindungsbolzens 8 in die exzentrische Erweiterung 11 im Lagerbock 2 einfahren, bis die in den Figuren 2 und 3 gezeigte Verrastposition erreicht ist.

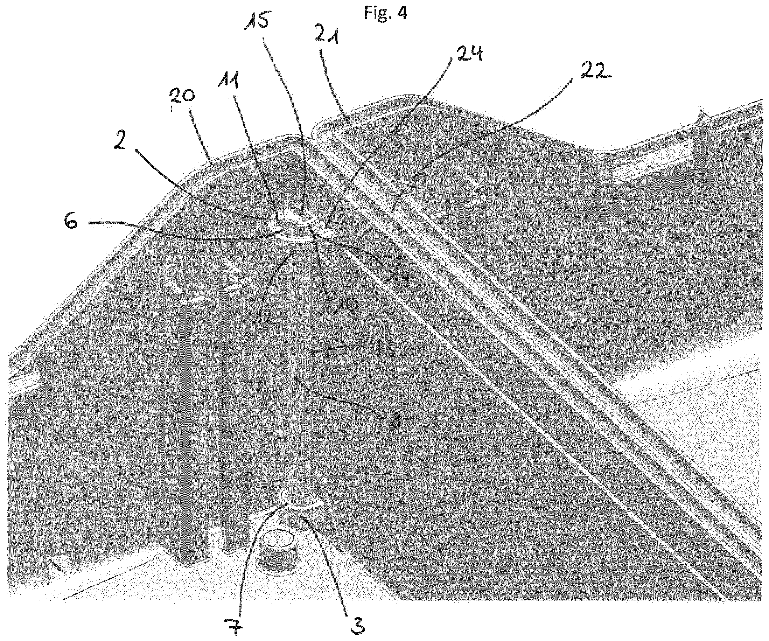

Die Figuren 4 bis 6 zeigen einen möglichen Einsatz des erfindungsgemäßen Verbindungssystems. Im gezeigten Ausführungsbeispiel sollen zwei Gehäuse 20 und 21 miteinander verbunden werden. Zu diesem Zweck liegen diese mit den Oberflächen im Verbindungsbereich 22 aufeinander. Die Oberflächen weisen geeignete Durchführungen 24 auf, sodass die Lagerböcke von einem Gehäuse 21 durch die Durchführungen 24 bis in das Innere des Gehäuses 20 hineinragen. Die Basisplatte 4 liegt dann an der inneren Oberfläche des Gehäuses 21 an.

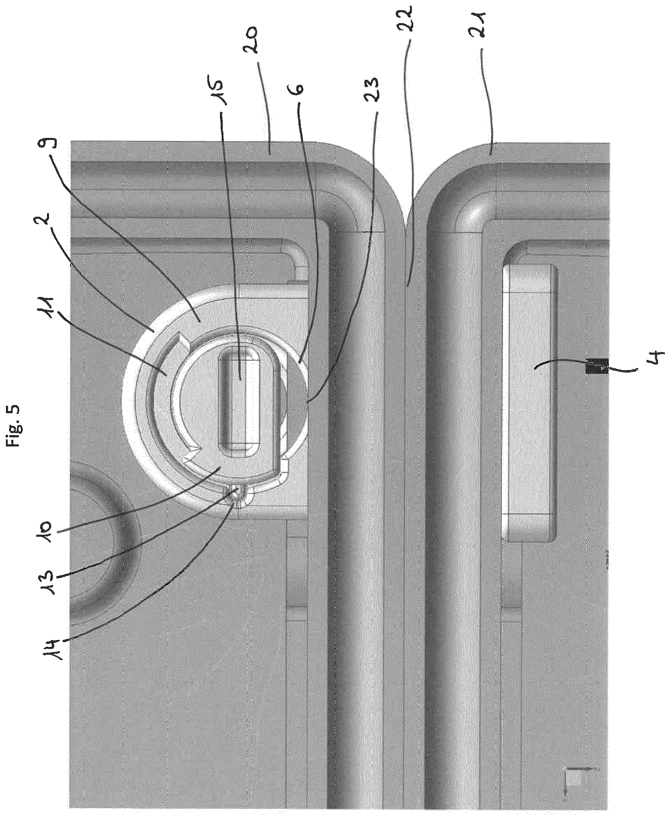

In die in das Gehäuse 20 hineinragenden Öffnungen der Lagerböcke 2 und 3 wird nunmehr der Verbindungsbolzen 8 eingeschoben. Zu diesem Zweck hat er zunächst die in den Figuren 4 und 5 gezeigte Position, bei welcher der Federsteg 13 in der Nut 14 geführt werden kann.

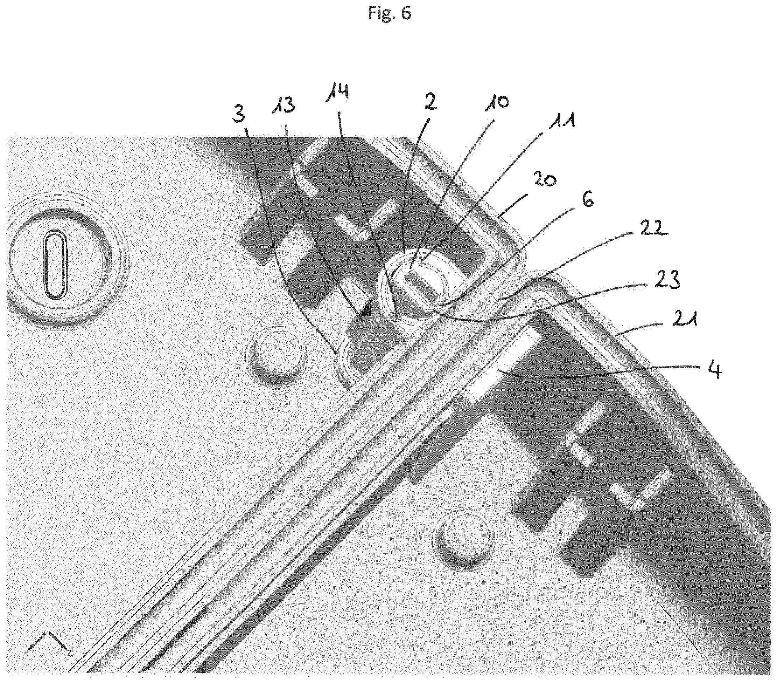

Die Figuren 5 und 6 zeigen, dass die Öffnung 6 in einem unteren Verspannungsbereich 23 zum Teil durch die Wandung des Gehäuses 20 abgedeckt ist. Wird nun der Verbindungsbolzen 8 betätigt, indem beispielsweise ein Schraubenzieher in den Betätigungsschlitz 15 eingesetzt und gedreht wird, erreicht der Verbindungsbolzen 8 die in Figur 6 gezeigte Position. Aufgrund der Exzentrizität verspannt sich nun der Bolzen im Verbindungsbereich 23 gegen die innere Oberfläche des Gehäuses 20. Dies erfolgt über die gesamte Länge des Verbindungsbolzens, sodass eine sehr gute Verbindung der beiden Gehäuse 20 und 21 auf einfachste Weise hergestellt ist.

Die beschriebenen Ausführungsbeispiele dienen nur der Erläuterung und sind nicht beschränkend.

### Bezugszeichen

- 1: Verbindungssystem
- 2: Lagerbock
- 3: Lagerbock
- 4: Basisplatte
- 5: Befestigungselement
- 6: Öffnung
- 7: Öffnung
- 8: Verbindungsbolzen
- 9: Stirnfront
- 10: Erweiterung Bolzen
- 11: Erweiterung Öffnung
- 12: Anschlag-/Rastnocken
- 13: Federsteg
- 14: Nut
- 15: Betätigungsschlitz
- 16: Auflauframpe
- 17: Rastnut
- 18: Bolzenquerschnitt
- 19: Anschlagkante
- 20: Gehäuse
- 21: Gehäuse
- 22: Verbindungsbereich
- 23: Verspannungsbereich
- 24: Durchführungen

## Patentansprüche

1. Verbindersystem, umfassend
wenigstens zwei Lagerböcke (2, 3), die jeweils eine Öffnung (6,7) aufweisen und die relativ zu einer Oberfläche befestigbar und derart positionierbar sind, dass die Öffnungen (6, 7) zueinander fluchten,
und einem Verbindungsbolzen (8), der die Lagerböcke (2, 3) verbindend in die zueinander fluchtenden Öffnungen (6, 7) einsetzbar ist,
wobei der Verbindungsbolzen (8) und wenigstens eine Öffnung (6, 7) ein zueinander passendes Paar aus einem Vorsprung und einer Ausnehmung aufweisen, so dass der Verbindungsbolzen (8) nur in einer bestimmungsgemäßen Verdrehposition in diese Öffnung (6, 7) einschiebbar ist, wobei der Verbindungsbolzen (8) ein exzentrisches Kopfstück aufweist, **dadurch gekennzeichnet, dass** die Exzentrik durch eine Durchmesser-Erweiterung in einem Kreissegment gebildet ist.

2. Verbindersystem nach Anspruch 1, **dadurch gekennzeichnet, dass** die Lagerböcke (2, 3) miteinander verbunden sind.

3. Verbindersystem nach Anspruch 2, **dadurch gekennzeichnet, dass** die Lagerböcke (2, 3) freistehend auf einer Basisplatte (4) angeordnet sind.

4. Verbindersystem nach Anspruch 3, **dadurch gekennzeichnet, dass** die Basisplatte (4) wenigstens ein Befestigungselement (5) aufweist.

5. Verbindersystem nach einem der vorhergehenden Ansprüche, **dadurch gekennzeichnet, dass** wenigstens ein Lagerbock (2) ein Anschlagelement zur Begrenzung der Drehbewegung des Verbindungsbolzens (8) aufweist.

6. Verbindersystem nach einem der vorhergehenden Ansprüche, **dadurch gekennzeichnet, dass** wenigstens ein Lagerbock (2) ein Rastelement aufweist, das mit dem Verbindungsbolzen (8) zusammenwirkt.

7. Verbindersystem nach den Ansprüchen 5 und 6, **dadurch gekennzeichnet, dass** das Anschlagelement und das Rastelement einstückig ausgebildet sind.

8. Verbindersystem nach Anspruch 7, **dadurch gekennzeichnet, dass** an wenigstens einem Lagerbock (2) ein Vorsprung ausgebildet ist, der mit einem Vorsprung am Verbindungsbolzen (8) zusammenwirkt.

9. Verbindersystem nach einem der vorhergehenden Ansprüche, **dadurch gekennzeichnet, dass** der Verbindungsbolzen (8) einen stegartigen Vorsprung (13) aufweist, der parallel zu einer Längsmittelachse des Verbindungsbolzens (8) verläuft.

10. Verbindersystem nach Anspruch 9, **dadurch gekennzeichnet, dass** der Vorsprung (13) die Endbereiche des Verbindungsbolzens (8) freilassend ausgebildet ist.

11. Verbindersystem nach einem der Ansprüche 9 oder 10, **dadurch gekennzeichnet, dass** der Vorsprung (13) mit einer Stirnkante mit dem Vorsprung am Lagerbock (2, 3) zusammenwirkt.

12. Verbindersystem nach einem der vorhergehenden Ansprüche, **dadurch gekennzeichnet, dass** wenigstens ein Lagerbock (2) im Bereich der Öffnung (6, 7) eine exzentrische Erweiterung in einem Kreissegment aufweist.

13. Verbindersystem nach einem der vorhergehenden Ansprüche, **dadurch gekennzeichnet, dass** der Verbindungsbolzen (8) beim Verdrehen in einem bestimmungsgemäß in die Öffnungen (6, 7) der Lagerböcke (2, 3) eingesetzten Zustand gegen eine von wenigstens einem der Lagerböcke (2, 3) durchragte Oberfläche verspannt wird.

## Claims

1. Connector system, comprising
at leasts two bearing blocks (2, 3), each of which has an opening (6, 7), and which can be fastened relative to a surface and positioned in such a way that the openings (6, 7) are aligned with one another,
and a connecting bolt (8) which, connecting the bearing blocks (2, 3), can be inserted in the openings (6, 7) aligned with one another,
wherein the connecting bolt (8) and at least one opening (6, 7) comprise a matching pair consisting of a projection and a recess, so that the connecting bolt (8) can be inserted in this opening (6, 7) only in an appropriate rotational position, wherein
the connecting bolt (8) comprises an eccentric head end, **characterised in that** the eccentricity is formed by an expansion of the diameter in a segment of a circle.

2. Connector system according to claim 1, **characterised in that** the bearing blocks (2, 3) are connected with one another.

3. Connector system according to claim 2, **characterised in that** the bearing blocks (2, 3) are arranged in a self-supporting manner on a base plate (4).

4. Connector system according to claim 3, **characterized in that** the base plate (4) comprises at least one fastening element (5).

5. Connector system according to one of the preceding claims, **characterised in that** at least one bearing block (2) comprises a stop element for limiting the rotary motion of the connecting bolt (8).

6. Connector system according to one of the preceding claims, **characterised in that** at least one bearing block (2) comprises a catch element which cooperates with the connecting bolt (8).

7. Connector system according to the claims 5 and 6, **characterised in that** the stop element and the catch element are designed integrally.

8. Connector system according to claim 7, **characterised in that** a projection is formed on at least one bearing block (2), which projection cooperates with a projection on the connecting bolt (8).

9. Connector system according to one of the preceding claims, **characterised in that** the connecting bolt (8) comprises a web-like projection (13) extending parallel to a longitudinal central axis of the connecting bolt (8).

10. Connector system according to claim 9, **characterised in that** the projection (13) is designed to spare the end areas of the connecting bolt (8).

11. Connector system according to one of the claims 9 or 10, **characterised in that** a front edge of the projection (13) cooperates with the projection on the bearing block (2, 3).

12. Connector system according to one of the preceding claims, **characterised in that** at least one bearing block (2) has an eccentric expansion in a segment of a circle in the area of the opening (6, 7).

13. Connector system according to one of the preceding claims, **characterised in that** the connecting bolt (8) is braced against a surface penetrated by at least one of the bearing blocks (2, 3), when the connecting bolt (8) is rotated while being appropriately inserted in the openings (6, 7) of the bearing blocks (2, 3).

## Revendications

1. Système de raccordement comprenant
au moins deux supports de palier (2, 3) qui présentent chacun une ouverture (6, 7) et qui peuvent être fixés par rapport à une surface et qui peuvent être positionnés de telle manière que les ouvertures (6, 7) sont alignées l'une avec l'autre
et un boulon de raccordement (8) qui peut être inséré dans les ouvertures alignées l'une avec l'autre (6, 7) en reliant les supports de palier,
cependant que le boulon de raccordement (8) et au moins une ouverture (6, 7) présentent une paire assortie d'une saillie et d'un évidement si bien que le boulon de raccordement (8) ne peut être inséré dans cette ouverture (6, 7) que dans une position de torsion conforme à la destination, cependant que le boulon de raccordement (9) présente une partie de tête excentrique, **caractérisé en ce que** l'excentricité est formé par un élargissement de diamètre dans un segment de cercle.

2. Système de raccordement selon la revendication 1, **caractérisé en ce que** les supports de palier (2, 3) sont reliés l'un à l'autre.

3. Système de raccordement selon la revendication 2, **caractérisé en ce que** les supports de palier (2, 3) sont placés de manière indépendante sur une plaque de base (4).

4. Système de raccordement selon la revendication 3, **caractérisé en ce que** la plaque de base (4) présente au moins un élément de fixation (5).

5. Système de raccordement selon l'une des revendications précédentes, **caractérisé en ce qu'**au moins un support de palier (2) présente un élément de butée pour délimiter le mouvement de rotation du boulon de raccordement (8).

6. Système de raccordement selon l'une des revendications précédentes, **caractérisé en ce qu'**au moins un support de palier (2) présente un élément d'encliquetage qui coopère avec le boulon de raccordement (8).

7. Système de raccordement selon les revendications 5 et 6, **caractérisé en ce que** l'élément de butée et l'élément d'encliquetage sont configurés en une pièce.

8. Système de raccordement selon la revendication 7, **caractérisé en ce qu'**une saillie qui coopère avec une saillie sur le boulon de raccordement (8) est configurée sur au moins un support de palier (2).

9. Système de raccordement selon l'une des revendications précédentes, **caractérisé en ce que** le boulon de raccordement (8) présente une saillie de type barrette (13) qui est parallèle à un axe médian longitudinal du boulon de raccordement (8).

10. Système de raccordement selon la revendication 9, **caractérisé en ce que** la saillie (13) est configurée en laissant libres les zones d'extrémité du boulon de raccordement (8).

11. Système de raccordement selon l'une des revendications 9 ou 10, **caractérisé en ce que** la saillie (13) coopère avec une arête frontale avec la saillie sur le support de palier (2, 3).

12. Système de raccordement selon l'une des revendications précédentes, **caractérisé en ce qu'**au moins un support de palier (2) présente, dans la zone de l'ouverture (6, 7), un élargissement excentrique dans un segment de cercle.

13. Système de raccordement selon l'une des revendications précédentes, **caractérisé en ce que** le boulon de raccordement (8) est serré contre une surface qui est pénétrée par au moins l'un des supports de palier (2, 3) lors de la torsion dans un état conforme à la destination mis en place dans les ouvertures (6, 7) des supports de palier (2, 3)
